# EUROPEAN PATENT APPLICATION

(11) **EP 4 832 353 A1**
(43) Date of publication of application: **28.10.2026**
(21) Application number: 26173244.0
(22) Date of filing: 20.04.2026
(51) Int. Cl.: H03M 13/13, H04L 1/00

(54) **DEEP Q-LEARNING NESTED INFORMATION SETS FOR PRECODED POLAR CODES**

(30) Priority: 25.04.2025 US 202563794728 P; 27.03.2026 US 202619631182
(71) Applicant: Samsung Electronics Co., Ltd., Suwon-si, Gyeonggi-do 16677 (KR)
(72) Inventor: HATAMI, Homayoon, San Jose, CA, 95134 (US); SABER, Hamid, San Jose, CA, 95134 (US); BAE, Jung Hyun, San Jose, CA, 95134 (US)
(74) Representative: Kuhnen & Wacker Patent- und Rechtsanwaltsbüro PartG mbB

(57) **Abstract**

A system and a method are disclosed for constructing nested information sets for precoded polar codes. A method includes constructing (310) a number of nested information sets based on a reliability sequence having a predefined reliability order and a length, determining (320) a number of components in the reliability sequence, reducing (330) a search space for a new reliability sequence by segmenting all bit positions in the reliability sequence into a number of groups, defining (340) a sequential decision process to identify the new reliability sequence that minimizes an average minimum required signal-to-noise ratio, SNR, for a target block error rate, BLER, across the number of nested information sets, utilizing (350) a reinforcement learning, RL, process to search the reduced search space for the new reliability sequence, and transmitting (360), through utilization of a polar encoder, a codeword generated through utilization of a rate-profiling module based on the new reliability sequence.

## Description

### TECHNICAL FIELD

The disclosure generally relates to data communication systems. More particularly, the subject matter disclosed herein relates to error-correcting coding for wireless communication systems.

### SUMMARY

Digital communication systems, including wireless cellular networks, satellite links, internet of things (IoT) devices, and other data communication environments, may employ polar codes and polarization-adjusted convolutional (PAC) codes to provide forward-error correction with favorable latency and implementation characteristics. A polar or PAC code may be characterized by an information-bit set (also referred to as a rate profile) that selects which polarized bit channels carry user data and which are fixed. System performance (e.g., block error rate (BLER)), complexity, and robustness across channel conditions, may depend on this selection.

To improve system performance, some solutions have used fixed tables, density-evolution or Gaussian-approximation driven constructions, heuristic searches, or handcrafted rules that tune the information set for a particular code length, rate, and decoder (e.g., successive-cancellation list (SCL) or cyclic-redundancy-check (CRC)-aided SCL). These approaches may produce rate profile configurations that allow the code to achieve acceptable BLER performance under one or more given assumptions, but they are often tailored to a narrow operating point, require significant computation when channel assumptions change, and/or do not readily use runtime feedback about how a given profile behaves on actual traffic or on a particular hardware pipeline.

Polar codes based on 0-1 rate assignments may waste capacity on partially reliable bit-channels and may be vulnerable to diverse deployment realities, such as mismatched channel models, list-size constraints, and/or content-dependent statistics. In practice, a modem may need a data-driven way to adapt or select information sets that generalize across signal-to-noise ratios (SNRs), bandwidth parts, and decoder configurations without an exhaustive reconstruction for each case.

Systems and methods are described herein for learning-based construction and selection of nested information sets for precoded polar codes. In various embodiments, nested information sets, which may be based on a single reliability sequence, may be constructed for the purpose of selecting a new reliability sequence. The new reliability sequence may be selected to minimize average of minimum SNR that may be required to achieve a target BLER across a range of operating conditions.

Various embodiments may provide faster acquisition of high-quality rate profiles, improved resilience to channel/model mismatch, compatibility with PAC pre-encoding, and portability across devices and applications, including cellular, satellite, and other digital communications systems.

In an embodiment, a method comprises constructing a number of nested information sets based on a reliability sequence having a predefined reliability order and a length. The number of nested information sets is equal to the length of the reliability sequence. The method comprises determining a number of components in the reliability sequence. The method comprises reducing a search space for a new reliability sequence by segmenting all bit positions in the reliability sequence into a number of groups. The number of groups is equal to the number of components in the reliability sequence. Each of the groups has a group length equal to the length of the reliability sequence divided by the number of components in the reliability sequence. The method comprises defining a sequential decision process to identify the new reliability sequence that minimizes an average minimum required SNR for a target BLER across the number of nested information sets. The method comprises utilizing a reinforcement learning (RL) process to search the reduced search space for the new reliability sequence. The method comprises transmitting, through utilization of a polar encoder, a codeword generated through utilization of a rate-profiling module based on the new reliability sequence.

In an embodiment, a system comprises a rate profiler configured to transform a source word into a data carrier word based on a number of nested information sets equal to a block length. The rate profiler is configured to select a number of indices equal to the code dimension from a number of possible indices equal to the block length. The system comprises an outer convolutional precoder configured to transform the data carrier word into a vector utilizing a one-to-one convolution operation based on an impulse response. The system comprises an inner polar encoder configured to transform the vector into a codeword utilizing a polar transform. The system comprises a transmitter configured to transmit the codeword.

The nested information sets may be based on a reliability sequence having a predefined reliability order and a length equal to the block length. The rate profiler may be further configured to: determine a number of components in the reliability sequence; reduce a search space for a new reliability sequence by segmenting all bit positions in the reliability sequence into a number of groups, the number of groups equal to the number of components in the reliability sequence, each of the groups having a group length equal to the length of the reliability sequence divided by the number of components in the reliability sequence; and define a sequential decision process to identify the new reliability sequence that minimizes an average minimum required signal-to-noise ratio (SNR) for a target block error rate (BLER) across the number of nested information sets.

### BRIEF DESCRIPTION OF THE DRAWING

In the following section, the aspects of the subject matter disclosed herein will be described with reference to exemplary embodiments illustrated in the figures, in which:
FIG. 1 is a block diagram illustrating a PAC encoder, according to an embodiment;
FIG. 2 is a block diagram illustrating a system for constructing nested information sets, according to an embodiment;
FIG. 3 is a flowchart illustrating a method of constructing nested information sets, according to an embodiment;
FIG. 4 is a flowchart illustrating a Markov decision process (MDP), according to an embodiment;
FIG. 5 is a block diagram of an electronic device in a network environment, according to an embodiment; and
FIG. 6 shows a system including a UE and a gNB in communication with each other.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "pre-coded," "Q-Network," "forward-error," etc.) may be occasionally interchangeably used with a corresponding non-hyphenated version (e.g., "precoded," "Q network," "forward error," etc.), and a capitalized entry (e.g., "Markov Decision Process," "Deep Q-Network," "Block Error Rate," etc.) may be interchangeably used with a corresponding non-capitalized version (e.g., "Markov decision process," "deep q-network," "block error rate," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

"0-1 rate assignment" as used herein refers to setting rate = 0 for one or more first bits in a bit channel, and setting rate = 1 for one or more second bits in the bit channel. Rate = 0 is utilized for fixing the input for the one or more first bits. Rate = 1 is utilized for sending bit information in uncoded form for the one or more second bits.

"Polar code" as used herein refers to a forward-error-correcting code produced by applying a polar transform to a sequence, optionally in combination with a precoder (in which case, the result is a pre-coded polar code) and rate-matching operations. Polar codes may be based on a 0-1 rate assignment. Some examples of "polar code" include: a binary polar code, a PAC code that includes a rate-1 convolutional precoder, or polar variants using mixed kernels or non-binary alphabets.

"Codeword" as used herein refers to an encoded sequence output by a PAC encoder that may include a rate-profiling stage, a convolutional precoder, and a polar transform. Some examples of "codeword" are an encoded block prior to modulation, an encoded block sent over a channel, and a shortened frame produced for latency or bandwidth constraints.

"Reliability sequence" as used herein refers to a sorted index array such that the elements of the reliability sequence are indices of the bit channels. The first element in the reliability sequence is the least reliable position, and the last element in the reliability sequence is the most reliable position. The other elements in the reliability sequence are sorted in order of reliability from the least to the most.

"Component code" as used herein refers to a subset of bits within a reliability sequence that is constructed to carry information bits for the components of the reliability sequence in the component code.

"Rate-profiling module" as used herein refers to hardware, firmware, and/or software configured to populate a vector by inserting message bits at indices and placing predetermined symbols (e.g., frozen zeros or CRC bits) at remaining indices, for input to a convolutional precoder and polar transform. Some examples of "rate-profiling module" are a firmware routine in a baseband processor, a hardware register-transfer level (RTL) block in an encoder pipeline, and a software library function executed by a processor.

"An episode" as used herein refers to a finite sequence of procedure steps beginning from an initial allocation tuple and applying a fixed or bounded number of updates to produce a selected allocation tuple.

The disclosed systems and methods may be applied in a variety of communication environments, including wireless cellular systems (e.g., fifth generation (5G), sixth generation (6G), and beyond), satellite communication links, loT networks, and other digital data transfer contexts. These environments may benefit from an improved rate profile because forward-error correction performance may affect latency, throughput, energy efficiency, and robustness under diverse operating conditions.

Various embodiments relate to constructing rate profiles for pre-coded polar codes, such as PAC codes. A rate profile may specify which bit positions of a length N codeword carry information-bits for a length K message and which positions are frozen.

Some embodiments may include rate-profile constructed PAC codes by simplifying the construction of information sets for a PAC code into the construction of nested information sets of component codes. Each component code may comprise a component length where the component length corresponds to the number of codeword bit positions included in that component code. The component codes may span all the bit channels of a reliability sequence. Within each component code, the bits may follow the same reliability order of the reliability sequence.

Some embodiments may define a Markov decision process (MDP) that formulates the task of identifying a new reliability sequence based on nested information sets that minimizes expected BLER. To achieve this, a deep Q-network (DQN) may be used with an experience replay buffer to determine the new reliability sequence with the lowest BLER. Use of these nested information sets may enhance the averaged required SNR across all N codes. Use of these nested information sets may improve BLER compared to use of other PAC codes. The disclosed systems and methods are not limited to the construction of PAC code information sets. The disclosed systems and methods may be applicable to information set construction for various pre-coded polar codes and may be utilized by various types of decoders. The MDP may be applicable to any BLER estimation method.

In an embodiment, a method may comprise constructing a number of nested information sets based on a reliability sequence having a predefined reliability order and a length. The number of nested information sets may be equal to the length of the reliability sequence. The method may comprise determining a number of components in the reliability sequence. The method may comprise reducing a search space for a new reliability sequence by segmenting all bit positions in the reliability sequence into a number of groups. The number of groups may be equal to the number of components in the reliability sequence. Each of the groups may have a group length equal to the length of the reliability sequence divided by the number of components in the reliability sequence. The method may comprise defining a sequential decision process to identify the new reliability sequence that minimizes an average minimum required SNR for a target BLER across the number of nested information sets. The method may comprise utilizing an RL process to search the reduced search space for the new reliability sequence. The method may comprise transmitting, through utilization of a polar encoder, a codeword generated through utilization of a rate-profiling module based on the new reliability sequence.

Some embodiments may include nested information sets. Nested information sets may comprise polar codes. Nested information sets may comprise precoded polar codes. Nested information sets may comprise PAC codes. Nested information sets may be based on a reliability sequence. The reliability sequence may comprise a predefined reliability order and a length. The length may be equal to a block length.

In an embodiment, a polar encoder comprises a PAC encoder. The PAC encoder may comprise a rate-1 convolutional precoder
Some embodiments may include a sequential decision process. The sequential decision process may comprise an MDP. The MDP may be defined by a state, action, transition probability, immediate reward, and discount factor. The state may comprise a tuple having a number of elements equal to a length of a reliability sequence. Each element of the tuple may be greater than or equal to 1 and less than or equal to a number of components in the reliability sequence. Each integer may appear a number of times equal to the length of the reliability sequence divided by the number of components in the reliability sequence. The action may be defined as a pair of integers. The second integer may comprise a fixed parameter. The first integer may be greater than or equal to 1 plus the second integer and less than or equal to the length of the reliability sequence. The action may be configured to swap elements in the current state having positions corresponding to the first integer, and the first integer minus the second integer. The transition probability may be deterministic. The immediate reward may comprise a reduction in the average logarithmic BLER across all code rates from a current state to a next state. The BLER may be evaluated at a reference SNR value. The reference SNR value may comprise the average minimum required SNR for the target BLER. The discount factor may be set to one.

In an embodiment, an MDP may comprise an episodic code construction. An episode may comprise a plurality of states, associated actions, and associated rewards. The MDP may be configured to maximize a cumulative reward based on a log BLER across the plurality of states.

Some embodiments may include an RL process. An RL process may comprise a DQN. The DQN may be utilized with an experience replay buffer.

In an embodiment, a system may comprise a rate profiler. The rate profiler may be configured to transform a source word into a data carrier word based on a number of nested information sets equal to a block length. The rate profiler may be configured to select a number of indices equal to the code dimension from a number of possible indices equal to the block length. The system may comprise an outer convolutional precoder configured to transform the data carrier word into a vector utilizing a one-to-one convolution operation based on an impulse response. The system may comprise an inner polar encoder configured to transform the vector into a codeword utilizing a polar transform. The system may comprise a transmitter configured to transmit the codeword.

In an embodiment, a rate profiler may be configured to determine a number of components in a reliability sequence. The rate profiler may be configured to reduce a search space for a new reliability sequence by segmenting all bit positions in the reliability sequence into a number of groups. The number of groups may be equal to the number of components in the reliability sequence. Each of the groups may comprise a group length equal to the length of the reliability sequence divided by the number of components in the reliability sequence. The rate profiler may be configured to define a sequential decision process to identify the new reliability sequence that minimizes an average minimum required SNR for a target BLER across a number of nested information sets. The rate profiler may be configured to utilize an RL process to search the reduced search space for the new reliability sequence.

In various embodiments, polar codes may be created based on the concept of 0 - 1 rate assignment of bit channels, meaning that setting *Rᵢ* = 0 corresponds to fixing the input to the *i*-th bit channel *Wᵢ*. Setting *Rᵢ* = 1 corresponds to sending information in uncoded form over the *i*-th bit-channel *Wᵢ.* PAC codes are often used because 0 - 1 rate assignments waste the capacities *C*(*Wᵢ*) of bit-channels *Wᵢ* whose inputs are fixed by the rate assignment *Rᵢ* = 0. The capacity loss may be greater at practical (small to moderate) block-lengths *N* since polarization takes place relatively slowly. In order to prevent such capacity loss, a need exists for systems and methods that avoid fixing the input of any bit-channel. PAC codes may be utilized to achieve this by placing an outer convolutional coding block with rate 1 in front of a polar transform. PAC code construction may be understood as serially concatenating an outer convolutional code with an inner polar code.

In an embodiment, for a (*N,K*) PAC code, *N* is the block length such that *N* = 2*ⁿ*, *n* ≥ 1, and *K* is the code dimension such that 1 *≤ K ≤ N.* The encoding operation for PAC codes is as follows: a rate-profiling block inserts the source word ***d*** = [*d*₀*, d*₁*,..., d*_{*K-*1} into a data carrier word ***v** =* [*v*₀*,v*₁*,..., v*_{*N-*1} in accordance with an information index set 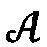 ⊆ {0, 1, . . . , *N* - 1}, | 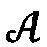 | *= K* so that 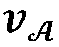 *= **d*** and 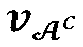 = **0**. Selection of *K* indices out of *N* possible indices may be referred to as rate-profile construction. The vector ***u*** is obtained from ***v*** by a one-to-one convolution operation, which may be characterized by an impulse response ***g*** = [*g*₀,...,*g*ₘ], where *g*₀ = 1 and *gₘ* = 1. The input-output relation may be represented as shown in Equation 1. ${u}_{i} = {\sum }_{j = 0}^{m} {g}_{j} {v}_{i - j} , for 0 \leq i \leq N - 1$ Equation 1 where ${v}_{k} = 0 for k < 0$

In an embodiment, codeword ***c*** may be obtained from vector ***u*** using ***c** = **uP**ₙ,* where ***P**ₙ = P*^{⊗n} is the polar transform defined as the nth Kronecker power of $P = \left[\begin{matrix}1 & 0 \\ 1 & 1\end{matrix}\right]$.

In some embodiments, a process of list decoding for PAC codes may be similar to that for polar codes except for the additional convolutional re-encoding at each decoding step for which the next memory state is stored for each path. Conceptually, this may be equivalent to having two lists that are kept at the decoder, one for ***u*** and another one for ***v*.**

Some embodiments may include nested information sets. "*A*" or *"* 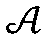 *"* may be used interchangeably to refer to an information set. Nested information sets 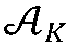 with | 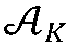 | = *K* for 1 ≤ *K* ≤ *N* and a given *N* are subsets of each other may be defined as 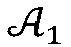 , ⊂ 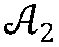 ⊂ 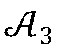 ... ⊂ 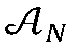 *.* A reliability sequence *π* may comprise a length N. A reliability sequence may be configured to specify all of the nested information sets. To obtain information set 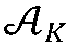 of length *K*, the last *K* elements of the reliability sequence **π** may be selected.

In various embodiments, a PAC code may be specified by four parameters (*N, K,* 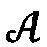 *,* **g**). Nested PAC codes may be specified by two parameters (**π**, ***g***). Determining effective construction rules for 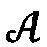 , (i.e., rate-profile construction) may be challenging. For example, the performance of a PAC code may be more sensitive to the choice of **π** than to **g**. The quality of a nested sequence of length *N* may be assessed by taking average of minimum required SNR of its (*N,K*) codes to achieve a target BLER for 1 ≤ *K* ≤ *N,* assuming that all (*N,K*) codes have equal importance (i.e., they are all equally likely to be utilized).

In various embodiments, nested information sets for M component codes may be constructed based on a reliability sequence of length N. Each component code may comprise a component length equal to $\frac{N}{M}$, where the component length corresponds to the number of codeword bit positions included in that component code. *M* component codes may span all the N-bit channels of (*N,K*) code 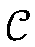 . The *i^{th}* component 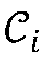 may contain the *i^{th}* chunk of $\frac{N}{M}$ bit channels. Within each component code, the bits may follow the same reliability order of the reliability sequence. The search space for a new reliability sequence may be reduced by a factor of ${\left(\frac{N}{M}!\right)}^{M}$.

In an embodiment, a system may be configured to construct a rate-profiler configured for *M* component codes 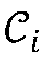 *, i* ∈ {1,2,.., M} for a length *N* PAC code 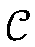 such that $\frac{N}{M}$ is an integer. The construction of a rate-profiler for a (*N,K*) PAC code may be based on constructing the component codes such that the component codes collectively include *K* information-bits.

In various embodiments, reliability order **π** is obtained from the reliability order **π***ₛ*, and a length-*N* array **π**', where each element of **π**' is a component index ranging from 1 to *M*, and each code index shows up exactly $\frac{N}{M}$ times in **π**'. Reliability sequence for length *N* PAC code, **π**, may comprise *N*! unique permutations. Finding the set of **π** may be simplified to finding **π**' given a fixed **π**ₛ. Finding **π**' given **π**ₛ in terms of minimizing the required average SNR to achieve a target BLER may be defined as a task within an MDP framework. A relationship between **π** and (**π**',**π**ₛ) may be defined as shown in Equations 2 and 3: $π ′ \left(i\right) = \left⌊\frac{\left(π\left(i\right)-1\right) M}{N}\right⌋ + 1$ Equation 2 where $\left⌊⋅\right⌋$ denotes a floor operation, and $π \left(i\right) = \frac{\left(π′\left(i\right)-1\right) N}{M} + {π}_{s} \left({\sum }_{k = 1}^{i} 1 \left(π′\left(k\right)=π′\left(i\right)\right)\right)$ Equation 3 where 1(*x*) returns 1 if *x* is true and 0 otherwise.

In an embodiment, Equation 3 may be utilized to find the bit index of the i-th least reliable bit, given the component index of the *i*-th least reliable bit and **π**ₛ. The first term in Equation 3 measures the number of bits that belong to components with component index smaller than **π**'(*i*). The second term in Equation 3 measures an index between 1 and $\frac{N}{M}$ for **π**ₛ, which is the number of bit positions in the target component code whose reliability is less than or equal to the reliability of the *i*-th least reliable bit channel.

In an example embodiment, a reliability order of a pre-coded polar code may be defined with the two parameters **π**' = [1,1,2,3,2,3,4,4] and πₛ = [2,1]. This implies that *N* = 8 and *M* = 4. The bit indices may be grouped as follows: {1,2}, {3,4}, {5,6}, and {7,8}, corresponding to component codes 1, 2, 3, and 4, respectively. A reliability sequence **π** may be obtained as described in the following: the least reliable bit may belong to component code 1, which corresponds to bit positions {1,2}. According to **π**ₛ, the least reliable bit in this component is bit 2, so **π**(1) = 2. The second least reliable bit may also belong to component code 1, and since this is the second occurrence, the second entry of **π**ₛ, which is bit 1, may be utilized producing **π**(2) = 1. The third least reliable bit may belong to component code 2 (bits {3,4}). Using the first value in **π**ₛ, bit 4 may be selected, so **π**(3) = 4. The fourth bit may belong to component code 3 (bits {5,6}), and similarly, **π**ₛ(1) = 2 selects bit 6, yielding **π**(4) = 6. The fifth least reliable bit may belong to component code 2. As this is the second visit to this component, **π**ₛ(2) = 1 may be used, corresponding to bit 3, so **π**(5) = 3. Continuing this process for the remaining entries, **π** = [2, 1, 4, 6, 3, 5, 8, 7].

In an example embodiment, if M and **π** are given, **π**' may be obtained. For example: M *=* 2 and **π** = [1, 2, 3, 5, 4, 6, 7, 8]. The bit indices may be grouped as follows: {1,2}, {3,4}, {5,6}, and {7,8}, corresponding to component codes 1, 2, 3, and 4, respectively. Traversing **π** from left to right, the first and second least reliable bits are 1 and 2, which both belong to component 1, so the first two entries of **π**' are 1. The third and fifth least reliable bits are 3 and 4, which belong to component 2, so the third and fifth entries of **π**' are 2. The fourth and sixth bits, 5 and 6, belong to component 3, so the fourth and sixth entries are 3. Continuing this process for the remaining entries, **π**' = [1, 1, 2, 3, 2, 3, 4, 4].

In an example embodiment, an MDP may be defined as follows:
**State:** An *N*-tuple **s** = (***s*₁*, s*₂*,*** . . . ***, s_{N}***) corresponding to **π**'. Each element may satisfy 1 ≤ sᵢ ≤ M, and every integer ranging from 1 to M may appear exactly $\frac{N}{M}$ times. This state may also be referred to as a current allocation tuple, which specifies the counts of information positions assigned to the respective components at a given stage of the construction process.
**Action:** A pair **a** = (*a, δ*), where *δ* + 1 *≤ a ≤ N,* and *δ* may comprise a fixed design parameter. The action swaps the a-th and (a - *δ*)-th elements of the current state. The action modifies the current state to generate the next state.
**Transition probability:** Given **s** and **a**, the next state s' may be specified deterministically.
**Immediate reward:** Let BLER*_{K}*(**s**) denote the BLER of (N,K) code corresponding to **s,** evaluated at a reference SNR value SNR*_{K}*(**s**ᵢₙᵢₜ), where SNR*_{K}*(**s**) is the minimum required SNR for *(N,K)* code to achieve BLERₜₐᵣ. The immediate reward r may be defined as the reduction in the average logarithmic BLER across all code rates from state **s** to state s' as follow shown in Equation 4. $r = {\sum }_{K = 1}^{N} \left(log \left({BLER}_{K}\left(s\right)\right)-log \left({BLER}_{K}\left(s′\right)\right)\right)$ Equation 4
**Discount factor:** γ = 1 in the MDP framework.

In an embodiment, a block-error performance may be quantified as a BLER, which may be measured for each information set derived from a current tuple. The allocation tuple corresponding to the lowest measured BLER within an episode may be selected as the preferred tuple. The BLER, for example, may be calculated via a Monte Carlo simulation for each state.

In an embodiment, an MDP may comprise an episodic task. The episodic task may comprise a sequence of states, actions, and rewards, starting with a fixed initial state **s**₁ = **s**ᵢₙᵢₜ and ending when the agent exhausts T number of moves. The episode may therefore be defined by the sequence (**s**₁ = **s**ᵢₙᵢₜ, **a**₁, *r*₁, **s**₂, **a**₂, *r*₂, ..., **a***_{T}, r_{T},* **s**_{*T*+1}). The agent may be configured to find actions within an episode that maximizes cumulative return by the following Equation 5. ${\sum }_{t = 1}^{T} {r}_{t} = {\sum }_{K = 1}^{N} \left(log \left({BLER}_{K}\left({s}_{init}\right)\right)\right. - {\sum }_{K = 1}^{N} \left(log \left({BLER}_{K}\left({s}_{T + 1}\right)\right)\right.$ Equation 5

According to an embodiment, an RL solution for a defined MDP may comprise a DQN with an experience replay buffer.

In an example embodiment, a DQN may be based on a Deep Q-Learning algorithm as follows:

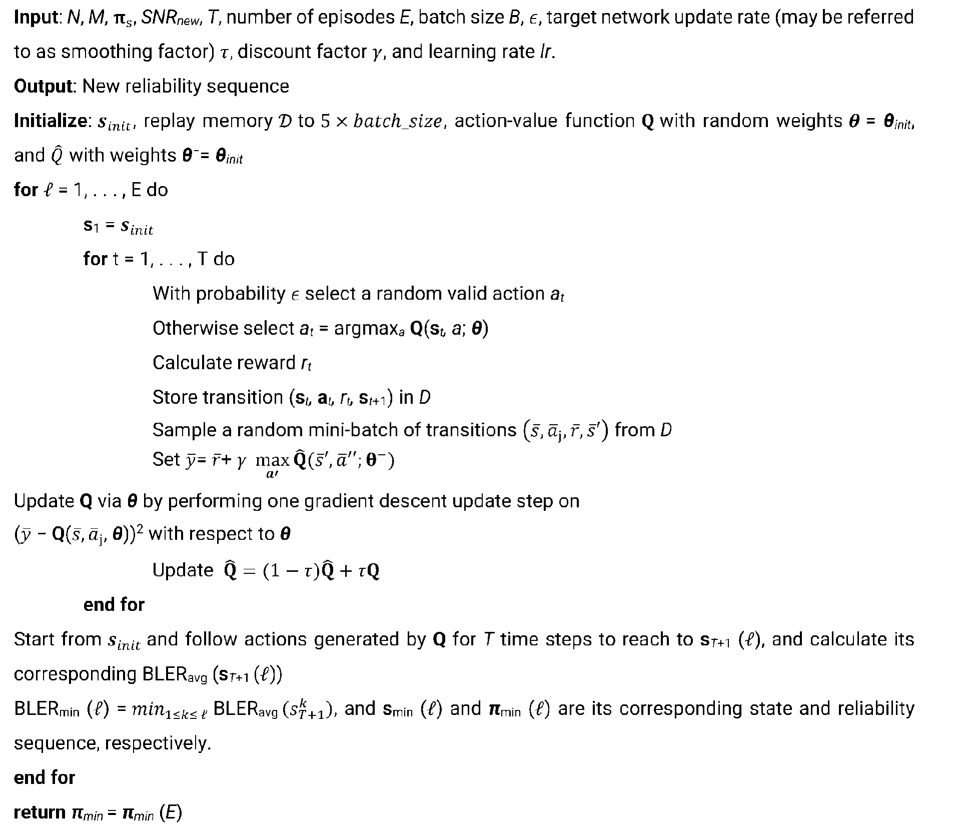

After the first round, the initial state at each round may be the best state from the previous round of training. The best state may comprise the state with the lowest observed BLER sampled after completing *T* steps, across all *E* epochs. The example algorithm above may be based on one or more of the following parameters:
**reliability sequence for component codes: π**ₛ of length $\frac{N}{M}$ is obtained based on the reliability sequence of 5G-NR polar code derived for length $\frac{N}{M}$. For example, for $\frac{N}{M} = 8$ , **π**ₛ = [1,2, 3, 5, 4, 6, 7, 8]. Array **π**ₛ is a construction parameter, and other reliability sequences for length $\frac{N}{M}$ may be adopted.
**initial state:** an initial state may be obtained by constructing **π**' from **π** of 5G-NR. Alternatively, other PAC/Polar codes may be adopted for setting ***s**ᵢₙᵢₜ.*
**neural network Q:** The input dimension is N, and output dimension is *N* - δ. The first layer may be a one-dimensional CNN layer with 100 output filters and kernel size 5. Next, 5 layers of 1D-CNN with 11 kernel size 5 each with 100 filters follows. In the final layer, a (100, 1) linear layer maps the (N - δ) × 100 dimension into (N - δ) × 1. Each CNN layer and the final linear layer may be followed by an ReLU activation function.
**optimizer:** AdamW.
**loss function:** is nn.SmoothL1Loss().
**component codes:** *M* = 8 and *M* = 16 when *N* = 64 and *N ∈* {256, 512}, respectively.
**action vector component:** δ = N as too small δ may lead to a slow convergence and relatively worse BLER_{avg}. Too large of δ may lead to faster convergence, but it may saturate quickly to a relatively worse BLER_{avg}.
**SNR_{new}**: At the BLERₜₐᵣ, SNR_{K} (***s**ᵢₙᵢₜ*) may be calculated for all 1 ≤ *K ≤ N.* BLERₜₐᵣ may comprise a range from 0.01 to 0.04 for different values of *N*. For larger *N*, larger value of BLER was selected to reduce the BLER simulation time during training.
**DQN replay buffer size:** 3000.
**exploration rate:** *∈* may be a function of total number of time steps denoted *tₜₒₜₐₗ* = *t + T ·* (ℓ -1) and parameters *∈ₛₜₐᵣₜ =* 0.9, *∈_{end} =* .001, and *∈_{decay}* = 300 as follows in Equation 6: $ϵ = {ϵ}_{end} + \left({ϵ}_{start}-{ϵ}_{end}\right) . {e}^{- \frac{{t}_{total}}{{ϵ}_{decay}}}$ Equation 6
**batch size:** B = 128, *T* = 100, *τ* = 0.005, γ = 0.99, *Ir* = 2× 10⁻⁵.

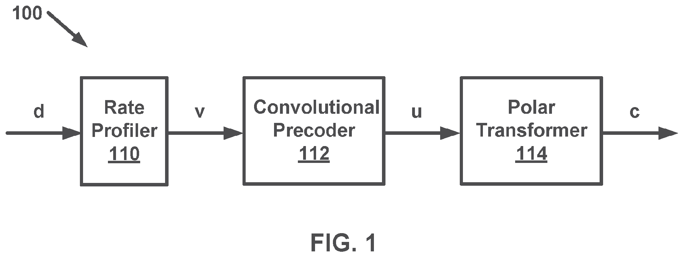

FIG. 1 is block diagram illustrating a PAC encoder 100, according to an embodiment.

Referring to FIG. 1, the PAC encoder 100 may comprise a rate profiler 110. The rate profiler 110 may be configured to transform a source word **d** into data carrier word v. The PAC encoder 100 may comprise a convolutional precoder 112. The convolutional precoder 112 may be configured to transform a data carrier word v into a vector ***u*.** The PAC encoder 100 may comprise a polar transformer 114. The polar transformer 114 may be configured to transform a vector ***u*** into a codeword ***c*.**

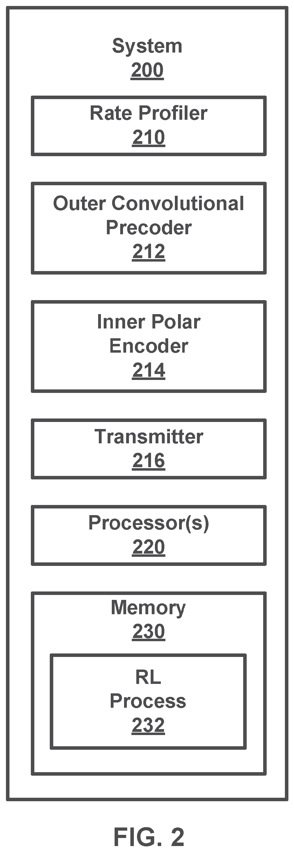

FIG. 2 is block diagram illustrating a system 200 for constructing nested information sets, according to an embodiment.

Referring to FIG. 2, the system 200 may comprise a rate profiler 210. The rate profiler 210 may comprise a rate-profiling module. The rate profiler 210 may be configured to transform a source word into a data carrier word based on a number of nested information sets equal to a block length. The rate profiler 210 may be configured to select a number of indices equal to a code dimension from a number of possible indices equal to the block length. The system 200 may comprise an outer convolutional precoder 212. The outer convolutional precoder 212 may comprise a precoding module. The outer convolutional precoder 212 may be configured to transform the data carrier word into a vector utilizing a one-to-one convolution operation based on an impulse response. The system 200 may comprise an inner polar encoder 214. The inner polar encoder 214 may comprise a polar transforming module. The inner polar encoder 214 may be configured to transform the vector into a codeword utilizing a polar transform. The rate profiler 210, outer convolutional precoder 212, and the inner polar encoder 214 may collectively comprise a PAC encoder. The system 200 may comprise a transmitter 216. The transmitter 216 may be configured to transmit the codeword. The system 200 may comprise one or more processors 220. The system 200 may comprise a memory 230. The memory 230 may comprise instructions that, when executed by the one or more processors 220, cause the one or more processors 220 to perform operations. The memory 230 may comprise an RL process 232. The RL process 232 may comprise instructions to search a reduced search space for a new reliability sequence.

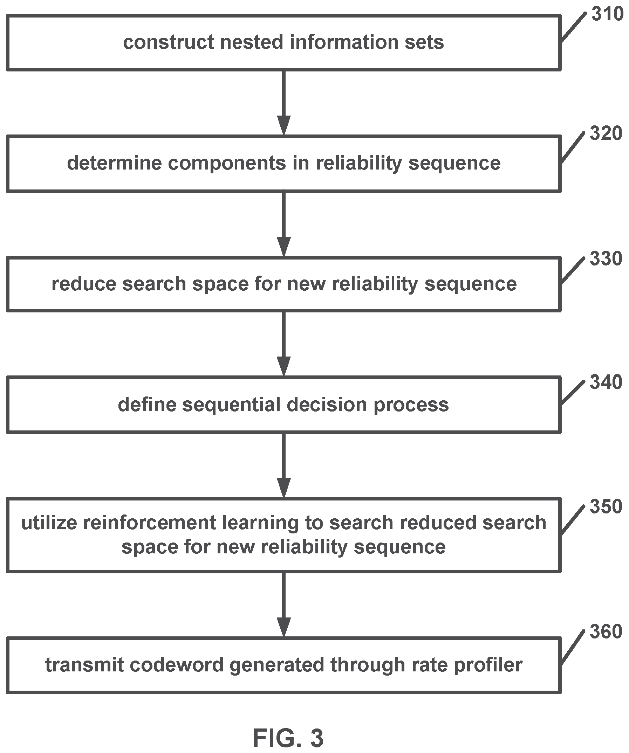

FIG. 3 is flowchart illustrating a method of constructing nested information sets, according to an embodiment.

Referring to FIG. 3, nested information sets may be constructed at 310. The nested information sets may be based on a reliability sequence. Components in the reliability sequence may be determined at 320. A search space for a new reliability sequence may be reduced at 330. The search space may be reduced by segmenting all bit positions in the reliability sequence into a number of groups. A sequential decision process may be defined at 340. The sequential decision process may be defined to identify the new reliability sequence that minimizes an average minimum required SNR for a target BLER across the nested information sets. An RL process may be utilized to search the reduced search space for the new reliability sequence at 350. A codeword generated through utilization of a rate profiler may be transmitted at 360. The codeword may be transmitted through utilization of a polar encoder. The rate profiler may be based on the new reliability sequence.

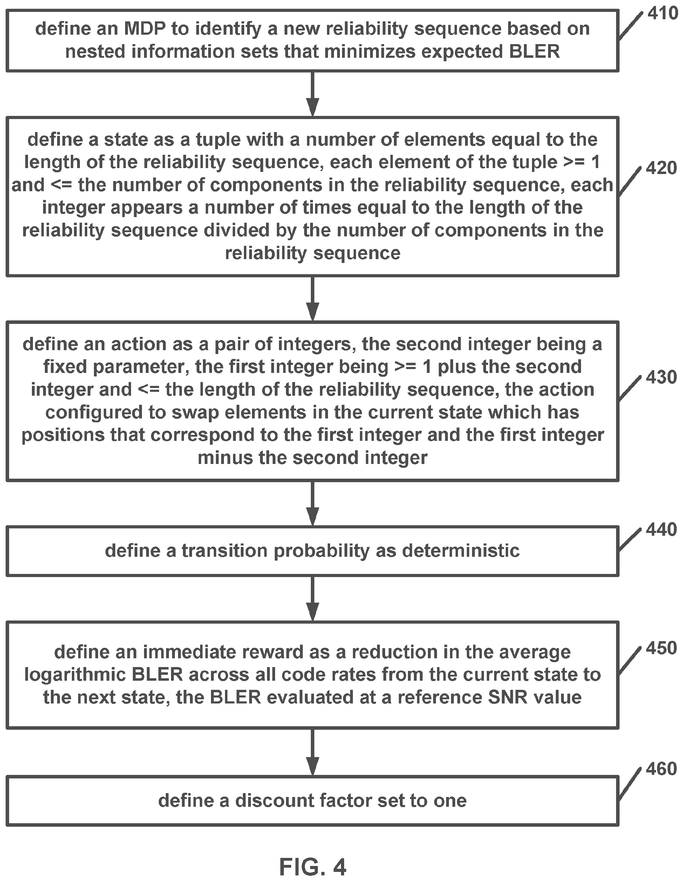

FIG. 4 is a flowchart illustrating a Markov decision process (MDP), according to an embodiment.

Referring to FIG. 4, an MDP may be defined at 410. The MDP may be defined to identify a new reliability sequence based on nested information sets that minimizes expected BLER. A state may be defined at 420. The state may be defined as a tuple with a number of elements equal to the length of the reliability sequence. Each element of the tuple may be greater than or equal to 1 and less than or equal to the number of components in the reliability sequence. Each integer may appear a number of times equal to the length of the reliability sequence divided by the number of components in the reliability sequence. An action may be defined at 430. The action may be defined as a pair of integers. The second integer may be a fixed parameter. The first integer may be greater than or equal to 1 plus the second integer, and less than or equal to the length of the reliability sequence. The action may be configured to swap elements in the current state which has positions corresponding to the first integer and the first integer minus the second integer. A transition probability may be defined at 440. The transition probability may be defined as deterministic. An immediate reward may be defined at 450. The immediate reward may be defined as a reduction in the average logarithmic BLER across all code rates from the current state to the next state. The BLER may be evaluated at a reference SNR value. The reference SNR value may comprise a vector of length N. Each element of the vector may correspond to one code rate, such that the Kth element of reference SNR is the minimum required SNR for the (N,K) code obtained from the reliability sequence to achieve the target BLER. A discount factor may be defined at 460. The discount factor may be set to one.

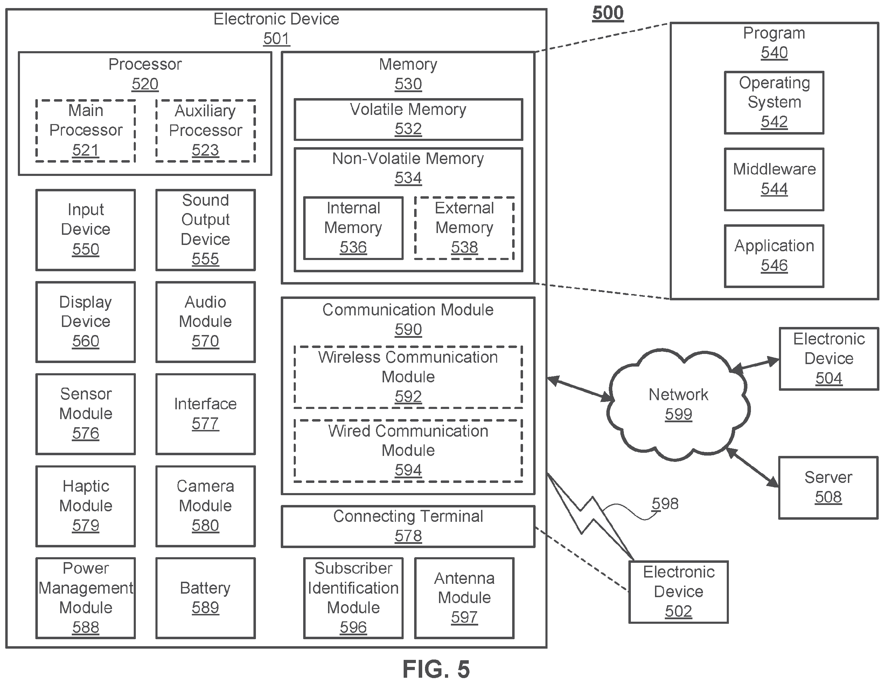

FIG. 5 is a block diagram of an electronic device in a network environment 500, according to an embodiment.

Referring to FIG. 5, an electronic device 501 in a network environment 500 may communicate with an electronic device 502 via a first network 598 (e.g., a short-range wireless communication network), or an electronic device 504 or a server 508 via a second network 599 (e.g., a long-range wireless communication network). The electronic device 501 may communicate with the electronic device 504 via the server 508. The electronic device 501 may include a processor 520, a memory 530, an input device 550, a sound output device 555, a display device 560, an audio module 570, a sensor module 576, an interface 577, a haptic module 579, a camera module 580, a power management module 588, a battery 589, a communication module 590, a subscriber identification module (SIM) card 596, or an antenna module 597. **In** one embodiment, at least one (e.g., the display device 560 or the camera module 580) of the components may be omitted from the electronic device 501, or one or more other components may be added to the electronic device 501. Some of the components may be implemented as a single integrated circuit (IC). For example, the sensor module 576 (e.g., a fingerprint sensor, an iris sensor, or an illuminance sensor) may be embedded in the display device 560 (e.g., a display).

The processor 520 may execute software (e.g., a program 540) to control at least one other component (e.g., a hardware or a software component) of the electronic device 501 coupled with the processor 520 and may perform various data processing or computations.

As at least part of the data processing or computations, the processor 520 may load a command or data received from another component (e.g., the sensor module 576 or the communication module 590) in volatile memory 532, process the command or the data stored in the volatile memory 532, and store resulting data in non-volatile memory 534. The processor 520 may include a main processor 521 (e.g., a central processing unit (CPU) or an application processor (AP)), and an auxiliary processor 523 (e.g., a graphics processing unit (GPU), an image signal processor (ISP), a sensor hub processor, or a communication processor (CP)) that is operable independently from, or in conjunction with, the main processor 521. Additionally or alternatively, the auxiliary processor 523 may be adapted to consume less power than the main processor 521, or execute a particular function. The auxiliary processor 523 may be implemented as being separate from, or a part of, the main processor 521.

The auxiliary processor 523 may control at least some of the functions or states related to at least one component (e.g., the display device 560, the sensor module 576, or the communication module 590) among the components of the electronic device 501, instead of the main processor 521 while the main processor 521 is in an inactive (e.g., sleep) state, or together with the main processor 521 while the main processor 521 is in an active state (e.g., executing an application). The auxiliary processor 523 (e.g., an image signal processor or a communication processor) may be implemented as part of another component (e.g., the camera module 580 or the communication module 590) functionally related to the auxiliary processor 523.

The memory 530 may store various data used by at least one component (e.g., the processor 520 or the sensor module 576) of the electronic device 501. The various data may include, for example, software (e.g., the program 540) and input data or output data for a command related thereto. The memory 530 may include the volatile memory 532 or the non-volatile memory 534. Non-volatile memory 534 may include internal memory 536 and/or external memory 538.

The program 540 may be stored in the memory 530 as software, and may include, for example, an operating system (OS) 542, middleware 544, or an application 546.

Furthermore, the processor 520 (e.g., main processor 521 with auxiliary processor 523) and the memory 530 may cooperatively implement a rate profiler. In particular, the processor 520 and the memory 530 may execute the encoding path of FIG. 1 (rate-profiling, convolutional pre-coding, and polar transforming) and/or the rate profiler, outer convolutional precoder, and the inner polar encoder of FIG. 2. For example, the program 540 stored in the memory 530 may include modules that (i) construct nested information sets from per-component allocations, (ii) execute a convolutional precoder and polar transform for encoding, and (iii) perform list-based decoding (e.g., SCL or CRC-aided SCL) for evaluation. The memory 530 may further store an RL process, learned model parameters *θ* for a DQN, channel and SNR configurations, rate-matching patterns, and checkpoints/logs from training and simulation. In some embodiments, a rate-profiling module retrieves the stored allocation tuples from memory and uses them to generate the nested information sets. The auxiliary processor 523 (e.g., GPU) may accelerate batch decoding and RL updates, while the main processor 521 may apply data movement and decision logic.

The communication module 590 and antenna module 597 may provide an interface to transmit and receive codewords generated by the encoder pipeline, and to obtain over-the-air performance measurements that may be fed back into the engine. During downlink reception, the communication module 590 may provide demodulated information (e.g., LLRs) to the processor 520 for execution of the blocks shown in FIG. 3 to decode message bits. During uplink transmission, the processor 520 may generate codewords using the current nested information sets. In some embodiments, the server 508 may store learned rate profiles. The interface 577 may import/export tuples between the electronic device 501 and the server 508. The SIM card 596 may provide network credentials for device-to-server coordination, while the power management module 588 and battery 589 may support prolonged operation during iterative training or field evaluation.

These structures may provide technical improvements. Constructing component codes and/or reducing a search space for a new reliability sequence may lower computation and memory usage versus exhaustive search, and enable faster convergence on the auxiliary processor 523. Storing reliability sequences and learned parameters in the memory 530 may permit reproducible construction of nested information sets with low latency at run time, which may reduce decoding complexity and improve block-error-rate performance across varying list sizes and channel conditions. Executing nested information set construction (e.g., as per the blocks shown in FIG. 3) using information from the communication module 590 may provide a consistent evaluation loop for new reliability sequence selection. Offloading evaluation and learning to the auxiliary processor 523 or server 508 may further improve computational efficiency.

The input device 550 may receive a command or data to be used by another component (e.g., the processor 520) of the electronic device 501, from the outside (e.g., a user) of the electronic device 501. The input device 550 may include, for example, a microphone, a mouse, or a keyboard.

The sound output device 555 may output sound signals to the outside of the electronic device 501. The sound output device 555 may include, for example, a speaker or a receiver. The speaker may be used for general purposes, such as playing multimedia or recording, and the receiver may be used for receiving an incoming call. The receiver may be implemented as being separate from, or a part of, the speaker.

The display device 560 may visually provide information to the outside (e.g., a user) of the electronic device 501. The display device 560 may include, for example, a display, a hologram device, or a projector and control circuitry to control a corresponding one of the display, hologram device, and projector. The display device 560 may include touch circuitry adapted to detect a touch, or sensor circuitry (e.g., a pressure sensor) adapted to measure the intensity of force incurred by the touch.

The audio module 570 may convert a sound into an electrical signal and vice versa. The audio module 570 may obtain the sound via the input device 550 or output the sound via the sound output device 555 or a headphone of an external electronic device 502 directly (e.g., wired) or wirelessly coupled with the electronic device 501.

The sensor module 576 may detect an operational state (e.g., power or temperature) of the electronic device 501 or an environmental state (e.g., a state of a user) external to the electronic device 501, and then generate an electrical signal or data value corresponding to the detected state. The sensor module 576 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 577 may support one or more specified protocols to be used for the electronic device 501 to be coupled with the external electronic device 502 directly (e.g., wired) or wirelessly. The interface 577 may include, for example, a high- definition multimedia interface (HDMI), a universal serial bus (USB) interface, a secure digital (SD) card interface, or an audio interface.

A connecting terminal 578 may include a connector via which the electronic device 501 may be physically connected with the external electronic device 502. The connecting terminal 578 may include, for example, an HDMI connector, a USB connector, an SD card connector, or an audio connector (e.g., a headphone connector).

The haptic module 579 may convert an electrical signal into a mechanical stimulus (e.g., a vibration or a movement) or an electrical stimulus which may be recognized by a user via tactile sensation or kinesthetic sensation. The haptic module 579 may include, for example, a motor, a piezoelectric element, or an electrical stimulator.

The camera module 580 may capture a still image or moving images. The camera module 580 may include one or more lenses, image sensors, image signal processors, or flashes. The power management module 588 may manage power supplied to the electronic device 501. The power management module 588 may be implemented as at least part of, for example, a power management integrated circuit (PMIC).

The battery 589 may supply power to at least one component of the electronic device 501. The battery 589 may include, for example, a primary cell which is not rechargeable, a secondary cell which is rechargeable, or a fuel cell.

The communication module 590 may support establishing a direct (e.g., wired) communication channel or a wireless communication channel between the electronic device 501 and the external electronic device (e.g., the electronic device 502, the electronic device 504, or the server 508) and performing communication via the established communication channel. The communication module 590 may include one or more communication processors that are operable independently from the processor 520 (e.g., the AP) and supports a direct (e.g., wired) communication or a wireless communication. The communication module 590 may include a wireless communication module 592 (e.g., a cellular communication module, a short-range wireless communication module, or a global navigation satellite system (GNSS) communication module) or a wired communication module 594 (e.g., a local area network (LAN) communication module or a power line communication (PLC) module). A corresponding one of these communication modules may communicate with the external electronic device via the first network 598 (e.g., a short-range communication network, such as BLUETOOTH^{™}, wireless-fidelity (Wi-Fi) direct, or a standard of the Infrared Data Association (IrDA)) or the second network 599 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 592 may identify and authenticate the electronic device 501 in a communication network, such as the first network 598 or the second network 599, using subscriber information (e.g., international mobile subscriber identity (IMSI)) stored in the subscriber identification module 596.

The antenna module 597 may transmit or receive a signal or power to or from the outside (e.g., the external electronic device) of the electronic device 501. The antenna module 597 may include one or more antennas, and, therefrom, at least one antenna appropriate for a communication scheme used in the communication network, such as the first network 598 or the second network 599, may be selected, for example, by the communication module 590 (e.g., the wireless communication module 592). The signal or the power may then be transmitted or received between the communication module 590 and the external electronic device via the selected at least one antenna.

Commands or data may be transmitted or received between the electronic device 501 and the external electronic device 504 via the server 508 coupled with the second network 599. Each of the electronic devices 502 and 504 may be a device of a same type as, or a different type, from the electronic device 501. All or some of operations to be executed at the electronic device 501 may be executed at one or more of the external electronic devices 502, 504, or 508. For example, if the electronic device 501 should perform a function or a service automatically, or in response to a request from a user or another device, the electronic device 501, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 501. The electronic device 501 may provide the outcome, with or without further processing of the outcome, as at least part of a reply to the request. To that end, a cloud computing, distributed computing, or client-server computing technology may be used, for example.

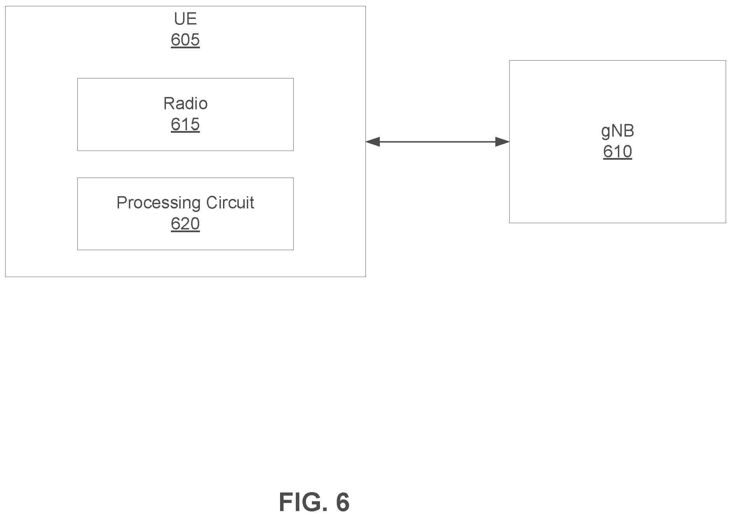

FIG. 6 is a system including a UE and a base station, in communication with each other, according to an embodiment.

Referring to FIG. 6, the UE may include a radio 615 and a processing circuit (or a means for processing) 620, which may perform various methods disclosed herein. For example, the processing circuit 620 may receive, via the radio 615, transmissions from a gNB (e.g., a BS, network node, satellite, or another electronic device) 610, and the processing circuit 620 may transmit, via the radio 615, signals to the gNB 610. In a downlink example, the radio 615 may provide information (e.g., LLRs) to the processing circuit 620, which may execute the blocks of FIG. 3. Decoded outcomes and BLER statistics may be logged for use by a rate-profiling module. In an uplink example, the processing circuit 620 may implement the rate profiler, the outer convolutional precoder, and/or the inner polar encoder of FIG. 2 to generate a codeword that the radio 615 may transmit to the gNB 610.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A computer-implemented method comprising:
constructing (310) a number of nested information sets based on a reliability sequence having a predefined reliability order and a length, the number of nested information sets being equal to the length of the reliability sequence;
determining (320) a number of components in the reliability sequence;
reducing (330) a search space for a new reliability sequence by segmenting all bit positions in the reliability sequence into a number of groups, the number of groups being equal to the number of components in the reliability sequence, each of the groups having a group length equal to the length of the reliability sequence divided by the number of components in the reliability sequence;
defining (340) a sequential decision process to identify the new reliability sequence that minimizes an average minimum required signal-to-noise ratio, SNR, for a target block error rate, BLER, across the number of nested information sets;
utilizing (350) a reinforcement learning, RL, process to search the reduced search space for the new reliability sequence; and
transmitting (360), through utilization of a polar encoder, a codeword generated through utilization of a rate-profiling module based on the new reliability sequence.

2. The method of claim 1, wherein the nested information sets comprise polarization-adjusted convolutional, PAC, codes.

3. The method of claim 2, wherein the polar encoder comprises a PAC encoder.

4. The method of any one of claims 1 to 3, wherein the sequential decision process comprises a Markov decision process, MDP.

5. The method of claim 4, wherein the MDP comprises:
a state being a tuple having a number of elements equal to the length of the reliability sequence, each element of the tuple being greater than or equal to 1 and less than or equal to the number of components in the reliability sequence, each integer appearing a number of times equal to the length of the reliability sequence divided by the number of components in the reliability sequence;
an action being defined as a pair of integers, the second integer being a fixed parameter, the first integer being greater than or equal to 1 plus the second integer and less than or equal to the length of the reliability sequence, the action being configured to swap elements in the current state having positions corresponding to the first integer and the first integer minus the second integer;
a transition probability being deterministic;
an immediate reward being a reduction in the average logarithmic BLER across all code rates from the current state to the next state, the BLER evaluated at a reference SNR value being the average minimum required SNR for the target BLER; and
a discount factor set to one.

6. The method of claim 5, further comprising an episodic code construction.

7. The method of claim 6, wherein an episode comprises a plurality of states, associated actions, and associated rewards, and the MDP is configured to maximize a cumulative reward based on a log BLER across the plurality of states.

8. The method of any one of claims 1 to 7, wherein the RL process comprises a deep Q-network, DQN.

9. The method of claim 8, wherein the DQN is utilized with an experience replay buffer.

10. A system comprising:
a rate profiler (210) being configured to transform a source word into a data carrier word based on a number of nested information sets equal to a block length, the nested information sets based on a reliability sequence having a predefined reliability order and a length equal to the block length, the rate profiler (210) being further configured to:
determine a number of components in the reliability sequence;
select a number of indices equal to a code dimension from a number of possible indices equal to the block length;
reduce a search space for a new reliability sequence by segmenting all bit positions in the reliability sequence into a number of groups, the number of groups equal to the number of components in the reliability sequence, each of the groups having a group length equal to the length of the reliability sequence divided by the number of components in the reliability sequence; and
define a sequential decision process to identify the new reliability sequence that minimizes an average minimum required signal-to-noise ratio, SNR, for a target block error rate, BLER, across the number of nested information sets;
an outer convolutional precoder (212) being configured to transform the data carrier word into a vector utilizing a one-to-one convolution operation based on an impulse response;
an inner polar encoder (214) being configured to transform the vector into a codeword utilizing a polar transform; and
a transmitter being configured to transmit the codeword.

11. The system of claim 10, wherein the rate profiler (210) is further configured to utilize a reinforcement learning (RL) process to search the reduced search space for the new reliability sequence.

12. The system of claim 10 or 11, wherein the nested information sets comprise polarization-adjusted convolutional, PAC, codes.

13. The system of claim 12, wherein the rate profiler (210), outer convolutional precoder (212), and the inner polar encoder (214) collectively comprise a PAC encoder.

14. The system of any one of claims 10 to 13, wherein the sequential decision process comprises a Markov decision process, MDP.

15. The system of claim 14, wherein the MDP comprises:
a state being a tuple having a number of elements equal to the length of the reliability sequence, each element of the tuple being greater than or equal to 1 and less than or equal to the number of components in the reliability sequence, each integer appearing a number of times equal to the length of the reliability sequence divided by the number of components in the reliability sequence;
an action defined as a pair of integers, the second integer being a fixed parameter, the first integer being greater than or equal to 1 plus the second integer and less than or equal to the length of the reliability sequence, the action being configured to swap elements in the current state having positions corresponding to the first integer and the first integer minus the second integer;
a transition probability being deterministic;
an immediate reward being a reduction in the average logarithmic BLER across all code rates from the current state to the next state, the BLER evaluated at a reference SNR value being the average minimum required SNR for the target BLER; and
a discount factor set to one.
